Europäisches Patentamt

(19) European Patent Office

Office européen des brevets

(11) Publication number: **0 443 802 A2**

# (12) EUROPEAN PATENT APPLICATION

(21) Application number: **91301282.9**

(22) Date of filing: **19.02.91**

(51) Int. Cl.⁵: **G03F 3/10**

(30) Priority: **20.02.90 GB 9003778**

(43) Date of publication of application:
**28.08.91 Bulletin 91/35**

(84) Designated Contracting States:
**DE FR NL**

(71) Applicant: **TRUPROOF LIMITED**
**Unit 4, Everitt Close, Denington Industrial**
**Estate**
**Wellingborough, Northamptonshire NN8 2QE**
**(GB)**

(72) Inventor: **Johnson, Ronald Frederick**
**Fairfield House Ford**
**Nr. Shrewsbury Shrophshire, SY5 9LG (GB)**

(74) Representative: **Goodenough, Nigel et al**
**A.A. Thornton & Co. Northumberland House**
**303-306 High Holborn**
**London WC1V 7LE (GB)**

(54) **Production of pre-press colour proofs.**

(57) A process for forming a pre-press proof of a coloured picture comprises applying a layer of coloured positive working photosensitive composition to a carrier, exposing the photosensitive composition through a positive transparency or colour separation to solubilize exposed portions of the photosensitive composition, developing the exposed layer using a water-based solvent, applying a protective transparent layer over the developed image, and repeating the process utilizing a different colour photosensitive composition and different positive transparencies or separations. By applying a transparent protective isolating layer between the coloured layers the developed layers are protected from the solvent used in developing a subsequent layer even though portions of the previous layer may have been rendered soluble by the exposure of the subsequent layer.

EP 0 443 802 A2

Jouve, 18, rue Saint-Denis, 75001 PARIS

# PRODUCTION OF PRE-PRESS COLOUR PROOFS

This invention relates to the production of pre-press colour proofs, and more particularly to a method of forming a proof of a picture which is to be printed using a multi-colour printing press.

Colour pictures, for example for books and magazines, are printed using multi-colour printing presses in which a plurality of printing plates are used to lay down successive layers of ink to build up the complete picture. The printing plates are produced from colour transparencies or separations which are themselves produced from the original photograph or art work to be reproduced.

It is recognized to be desirable to produce proof copies of the proposed printed picture prior to the production of the printing plates. Such proofs enable potential faults in the colour separations to be corrected before the printing plates are produced. Desirably, the proofs are produced using printing inks containing the same pigments as those to be used in the printing press thereby enabling the colours of the eventual printed picture to be determined before the printing plates are produced. A process for producing colour proofs in this manner is described in GB-A-1150648.

The process described in GB-A-1150648 require the use of negative colour separations or transparencies. This is a disadvantage because the techniques commonly used for the production of printing plates require the production of positive colour separations or transparencies, and accordingly if the techniques of GB-A-1150648 are used a separate set of negative colour transparencies or separations must be produced for the purpose of producing pre-press proofs. This is clearly undesirable.

Although GB-A-1150648 suggests that the processes described therein can be operated using a positive transparency there is no disclosure how this may be carried out in the case of a multi-colour image. It will be appreciated that when using a resist which is initially insoluble and is subsequently rendered soluble by exposure to light via a positive transparency, the areas of colour remaining after development are themselves liable to be rendered soluble by exposure to light during a subsequent processing step, for example the exposure of the partially completed proof through a positive transparency or separation for a different colour. Thus, if attempts are made to operate the process of GB-A-1150648 utilizing multiple exposures via different positive colour separations or transparencies the resulting proof is liable to contain substantial inaccuracies in all the colours except the last one to be laid down. There is nothing in the disclosure of GB-A-1150648 which addresses this problem or the manner in which it is to be overcome.

GB-A-989542 suggests a process for producing a decorative print from a diapositive. However, the process described therein is inherently unsuitable for the production of high quality multi-colour proofs of the type to which the present invention relates and is apparently intended primarily for the purposes of producing decorative finishes on items of furniture.

According to the present invention there is provided a method of forming a proof of a picture which is to be printed using a multi-colour printing press, the method comprising the steps of :

(a) producing a positive transparency or separation corresponding to each colour plate to be used in the printing press ;

(b) applying a layer of coloured positive-working photosensitive composition, capable of being developed with a water based solvent, to the substrate ;

(c) subjecting the photosensitive layer to irradiation through one of the said positive transparencies or separation to solubilize portions of the photosensitive layer exposed to radiation ;

(d) developing the irradiated layer by removing exposed portions of the photosensitive coating by means of an appropriate water-based solvent ;

(e) applying a protective transparent layer of an isolating polymer composition, resistant to the solvent used in step (d), over the surface of the substrate and remaining portions of the photosensitive layer ; and

(f) repeating steps (b)-(e) using each of the positive transparencies or separations in turn to produce a proof of the picture.

By applying a protective transparent layer of an isolating polymer composition to each colour layer after development, the colour image of that layer is protected from the action of the solvent during the development of an overlying colour layer even though the photosensitive composition of the first layer has been exposed to solubilizing light during exposure of the overlying layer.

It will be noted that the photosensitive compositions utilized in the invention are capable of being developed with a water based solvent. If the protective transparent layer of isolating polymer composition is also water carried, but is resistant to water based solvents after drying, the entire method can be performed without using any organic solvents other than any which may be contained in the photosensitive composition. This is clearly advantageous for economic, safety and environmental reasons.

In order that the invention may be well understood, reference will now be made to the accompanying drawings which are schematic illustrations of various stages in the process of the invention.

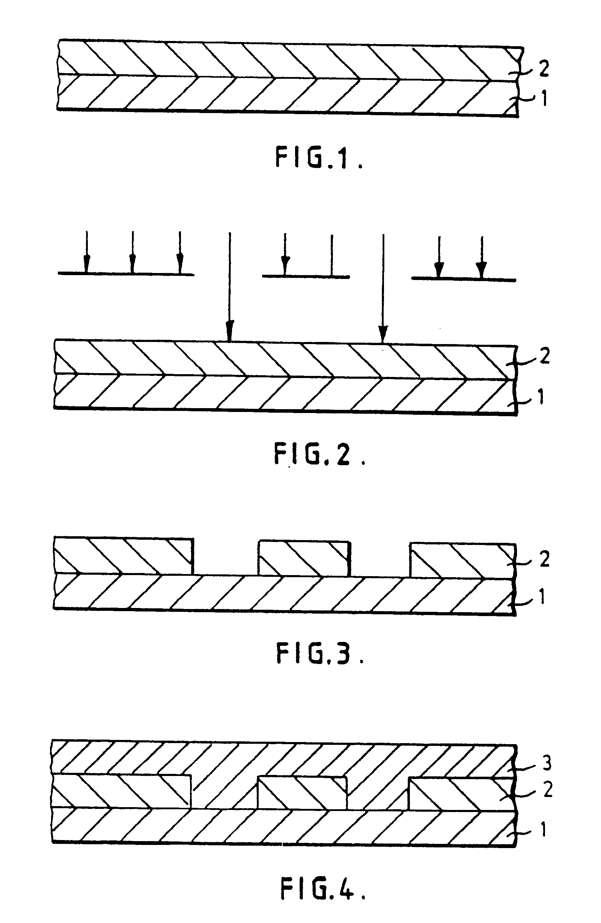

The first stage of the invention comprises applying a layer (2) of a coloured, positive-working photosensitive material to a substrate (1) to give a coated substrate as shown in Figure 1 of the drawings. The substrate is preferably a water impermeable substrate such as tin plate or a synthetic, e.g. polypropylene, paper such as that sold under the Registered Trade Mark "Synteape". Alternatively the substrate may be a water absorbent or water-permeable substrate, including the actual stock to be printed, which has been rendered water-impermeable by application of a suitable coating thereto, e.g. a coating of an acrylic resin of an acrylic /PVdC copolymer. The substrate may be further provided with an additional coating of a key coat or anti-staining coat which may be a polymer similar to those discussed above in connection with the coating of water-permeable substrates. Such a coating may be applied by means of a Meyer bar, gravure roller, a cascade, a curtain, a knife, a Kershaw loop, or hot roller. A preferred method of applying a key or anti-staining coat is by means of a Meyer bar.

The photosensitive polymer composition applied to the substrate is a positive working, water-developable system. That is, the composition is one which, having been applied to a substrate and dried, affords a water-resistant layer which on exposure to appropriate radiation, typically UV-radiation, is rendered soluble in water or a water-based solvent system. A preferred solvent system is water itself but other water-based systems which may be employed include weakly alkaline aqueous solutions such as 5-10% aqueous sodium carbonate solution. Generally preferred photosensitive polymer compositions are those based on o-quinone diazide photosensitive materials such as described, for example in "Light-Sensitive Systems", J. Kosar, John Wiley, 1965, at pages 339 and 342-351. A generally preferred class of photosensitive materials comprises those obtained by reacting a sulphonyl group-containing o-quinone diazide with a phenol-formaldehyde resin, e.g. as disclosed in US-A-3046120. Particularly preferred photosensitive materials are those obtained by reacting 2,1,5-naphthoquinone diazide with a phenolic resin.

The photosensitive composition should be coloured, preferably by means of a pigment, and, typically, will be black, mageta, cyan or yellow in colour ; a combination of two or more of these, generally all four, will be used to produce the desired image.

The photosensitive composition is applied to the substrate by any suitable means, e.g. as discussed above, and then dried, suitably to give a layer having a thickness of from 0.25 to 20 micrometres.

In the second stage of the process (see Figure 2), the coated substrate is subjected to imagewise irradiation through an appropriate positive transparency or separation, for example a positive continuous tone or screened transparency separation. The radiation employed will, of course, be that suitable to solubilize the photosensitive composition applied to the substrate and thus, there may be used, as a radiation source, a lamp emitting radiation in the 370-410 nanometre range.

In the next stage of the process of the invention, the irradiated photosensitive layer is "developed", that is portions of the photosensitive layer subjected to irradiation are removed by application of a suitable aqueous solvent such as 5% aqueous sodium silicate solution or 5-10% aqueous sodium carbonate solution. The developed plate is then dried by suitable means such as by warm air or by infra-red drying to give a product as shown in Figure 3 comprising unexposed portions, 2, of photosensitive polymer upon substrate 1.

In the next stage of the process of the invention a second coating, 3, of a transparent protective, non-photosensitive, polymer composition is applied to the developed and dried plate (see Figure 4 of the drawings). The polymer system in this composition is suitably one as discussed above in connection with the treatment of permeable substrates. The polymer system must be one which gives a film resistant to the development solvent used in the succeeding stage of the invention.

Particularly preferred protective polymers are those which may be applied as acrylic polymer emulsions, e.g. those sold by Rohm Haas under the trade names 2212, EP-4290 and E-2426. The second, protective layer is dried, suitably to give a coating having a thickness of from 0.25 to 20 micrometres.

The whole process is then repeated, using differently coloured photosensitive compositions, to build up superimposed images on the substrate and thus to give a final coloured image.

In order that the invention may be well understood the following examples are given by way of illustration only.

EXAMPLE

10 parts by weight of a phenolic resin (Alnovol PN 430), 20 parts by weight of 2,1,5-naphthoquinone diazide, and 70 parts by weight of acetone were mixed together under agitation until the solids had totally dissolved. The reaction product was then separated from the reaction mixture using a rotary evaporator to remove the solvent. The solid mass obtained was placed in a drying cabinet (80oF) for two days. 40 parts by weight of the resultant light-sensitive condensate were dispersed in 100 parts by weight of acetone to give a pale yellow liquid. 100 parts by weight of this liquid were mixed with 20 parts by weight of a solution prepared from 40 parts by weight of cellulose acetate propionate and 100 parts of acetone. The resultant composition was used as a base composition for the preparation of various inks by dispersing 20 parts of an appropriately coloured pigment dispersion (BASF Enceprint) in 100 parts by weight of the resin. Pre-press proofs were made using black, cyan, magenta and yellow photosensitive resins, obtained as described above, in turn and using, as protective resin the acrylic emulsions sold by Rohm and Haas under the Trade Name EP-2212. Each stage in the process basically comprised applying a layer, about 7 micrometres thick, of the appropriate coloured photosensitive resin to a substrate, allowing it to dry, exposing to UV irradiation from a 370-410 nanometre lamp through an appropriate colour separation, dissolving away exposed portions of the photosensitive layer using 10% aqueous sodium carbonate solution, applying a layer of the protective resin, about 12 micrometres thick, to the developed layer, and drying it. These stages were repeated for each of the four colours to give pre-press proof.

## Claims

1. A method of forming a proof of a picture which is to be printed using a multi-colour printing press, the method comprising the steps of :
   (a) producing a positive transparency or separation corresponding to each colour plate to be used in the printing press ;
   (b) applying a layer of coloured positive-working photosensitive composition, capable of being developed with a water based solvent, to the substrate ;
   (c) subjecting the photosensitive layer to irradiation through one of the said positive transparencies or separation to solubilize portions of the photosensitive layer exposed to radiation ;
   (d) developing the irradiated layer by removing exposed portions of the photosensitive coating by means of an appropriate water-based solvent ;
   (e) applying a protective transparent layer of an isolating polymer composition, resistant to the solvent used in step (d), over the surface of the substrate and remaining portions of the photosensitive layer ; and
   (f) repeating steps (b)-(e) using each of the positive transparencies or separations in turn to produce a proof of the picture.

2. A method as claimed in claim 1 in which at least one of the photosensitive compositions is a polymer containing a o-quinone diazide photosensitive material.

3. A method as claimed in claim 1 or claim 2 wherein each layer of coloured photosensitive composition contains a pigment corresponding to that to be used in a respective stage of the proposed printing process whereby the proof accurately indicates the colours to be expected in the printed picture.

4. A method as claimed in claim 1 or claim 2 wherein the protective transparent layer is carried in an aqueous base and is rendered insoluble in a water-based solvent upon drying.

5. A method as claimed in claim 1 substantially as hereinbefore described.

FIG.1.

FIG.2.

FIG.3.

FIG.4.